Europäisches Patentamt

European Patent Office

Office européen des brevets

(11) Numéro de publication: **0 098 668**
**B1**

# FASCICULE DE BREVET EUROPEEN

(45) Date de publication du fascicule du brevet:
**16.09.87**

(21) Numéro de dépôt: **83200997.1**

(22) Date de dépôt: **05.07.83**

(51) Int. Cl.⁴: **H 03 K 7/06**

(54) **Modulateur pour transmission de données analogiques.**

(30) Priorité: **07.07.82 FR 8211925**

(43) Date de publication de la demande:
**18.01.84 Bulletin 84/3**

(45) Mention de la délivrance du brevet:
**16.09.87 Bulletin 87/38**

(84) Etats contractants désignés:
**BE CH DE FR GB IT LI NL SE**

(56) Documents cités:
**EP - A - 0 017 301**
**FR - A - 1 586 096**
**US - A - 3 835 419**

**PROCEEDINGS OF THE IEE, vol. 123, no. 9, septembre 1976, pages 931-932, Stevenage, Herts., GB, D. MILICEVIC et al.:"Hybrid structure of voltage-frequency convertor for power-frequency conversion"**

(73) Titulaire: **TELECOMMUNICATIONS RADIOELECTRIQUES ET TELEPHONIQUES T.R.T., 88, rue Brillat Savarin, F-75013 Paris (FR)**

(72) Inventeur: **Boudault, Robert, Societe Civile S.P.I.D. 209 rue de l'Université, F-75007 Paris (FR)**

(74) Mandataire: **Charpail, François et al, Société Civile S.P.I.D. 209, rue de l'Université, F-75007 Paris (FR)**

## Description

L'invention concerne un modulateur destiné à transmettre un signal de données analogiques par la variation de la fréquence d'un oscillateur comportant un premier amplificateur opérationnel monté avec un condensateur pour former un intégrateur dont la sortie est reliée à l'entrée d'une bascule à seuil avec hystérésis, la sortie de la bascule à seuil fournissant une tension bivalente étant connectée à une borne d'une première résistance dont l'autre borne est à relier à l'entrée dudit intégrateur de façon à former à la sortie de ce dernier une tension triangulaire dont la fréquence dépend du courant qui le traverse, ladite bascule à seuil étant constituée par un deuxième amplificateur opérationnel suivi d'un inverseur, une entrée de cet amplificateur opérationnel étant reliée à la borne intermédiaire d'un pont de résistances connecté entre lesdites sorties de l'intégrateur et de la bascule à seuil.

Un modulateur de ce genre peut être utilisé dans le cas où l'on désire transmettre sous forme analogique, car plus commode et plus économique, des informations issues de capteurs divers tels que par exemple enregistreurs, sondes thermométriques etc. . .

Une autre utilisation d'un tel modulateur est intéressante pour la transmission de données analogiques médicales (par exemple des enregistrements d'électrocardiogrammes) sur ligne téléphonique, d'un poste d'abonné à une station centrale. Dans ce cas la transmission doit être conforme à l'avis V 16 du CCITT.

Le document FR-A-2 453 536 décrit un modulatuer comportant un oscillateur à tension de sortie triangulaire du genre décrit dans le préambule et qui transmet des données numériques par un même déplacement de fréquence autour de deux fréquences centrales distinctes.

La présente invention vise à fournir un modulateur pour transmission de données analogiques par la variation linéaire de la fréquence de l'ocillateur obtenue par la variation continue du courant de charge ou de décharge du condensateur de l'intégrateur en fonction du signal de données. L'invention a pour but également de fournir les moyens permettant d'obtenir une très grande stabilité en fréquence vis à vis de la tension d'alimentation et de la température ainsi qu'une fiabilité accrue.

Conformément à l'invention, ladite tension bivalente à la sortie de la bascule à seuil est formée à partir du potentiel zéro de la masse et d'un potentiel positif fixe inférieur à la tension d'alimentation U appliqués respectivement aux entrées d'un premier et d'un deuxième commutateur analogiques dont les sorties communes sont reliées à ladite sortie de la bascule à seuil, les signaux d'entrée et de sortie dudit inverseur servant à commander respectivement lesdits premier et deuxième commutateurs, ledit signal de données étant appliqué à l'entrée d'un circuit de transformation des données analogiques agencé pour fournir à ses sorties une première et une seconde tension variables en fonction du signal de données, de façon symétrique par rapport à la moyenne des potentiels fixes à l'entrée desdits premier et deuxième commutateurs, lesdites premières et seconde tensions variables étant appliquées respectivement aux entrées d'un troisième et d'un quatrième commutateur analogiques ayant leurs sorties communes reliées à un borne d'une deuxième résistance dont l'autre borne est commune avec celle de ladite première résistance, lesdits signaux d'entrée et de sortie de l'inverseur servant à commander respectivement lesdits troisième et quatrième commutateurs.

Le document FR-A-1 586 096 décrit un modulateur qui emploie des commutateurs analogiques pour générer des échelons de tension dans un circuit comportant un oscillateur à tension de sortie triangulaire mais dans ledit modulateur la fréquence centrale dépend de la tension d'alimentation alors que le modulateur selon la présente demande permet de rendre ladite fréquence centrale indépendante de la tension d'alimentation; de plus de faibles variations de la tension d'entrée ne peuvent être prises en compte.

Le modulateur selon l'invention peut transmettre également un signal de données numériques par un déplacement de fréquence donné en connectant à l'entrée dudit circuit de transformation des données analogiques la sortie d'un circuit de transformation des données numériques transformant un signal de commande appliqué à son entrée et dont les valeurs de potentiel sont $+U$ et $-U$ en un autre signal de commande dont les valeurs du potentiel sont déterminées pour produire ledit déplacement de fréquence.

La description suivante en regard des dessins annexés, le tout donné à titre d'exemple, fera bien comprendre comment l'invention peut être réalisée.

La figure 1 représente un schéma du modulateur de l'invention.

Sur la figure 2, le diagramme 2a représente la tension à l'entrée de la bascule à seuil, le diagramme 2b représente la tension à l'entrée de l'inverseur de la bascule à seuil, le diagramme 2c représente la tension à la sortie de cette bascule, le diagramme 2d représente la tension triangulaire à la sortie de l'intégrateur et le diagramme 2e représente la tension à la sortie commune des troisième et quatrième commutateurs.

La figure 3 est un schéma de l'oscillateur utilisé dans le modulateur de l'invention.

La figure 4 montre le réseau de résistances connecté à l'entrée de l'intégrateur et les tensions qui sont appliquées à ce réseau.

La figure 5 donne la caractéristique fréquence-tension d'un modulateur conforme aux normes du CCITT pour la transmission de données analogiques médicales.

La figure 6 représente un schéma du circuit de transformation des données numériques ainsi que la modification du schéma qui lui correspond dans le circuit de transformation des données analogiques.

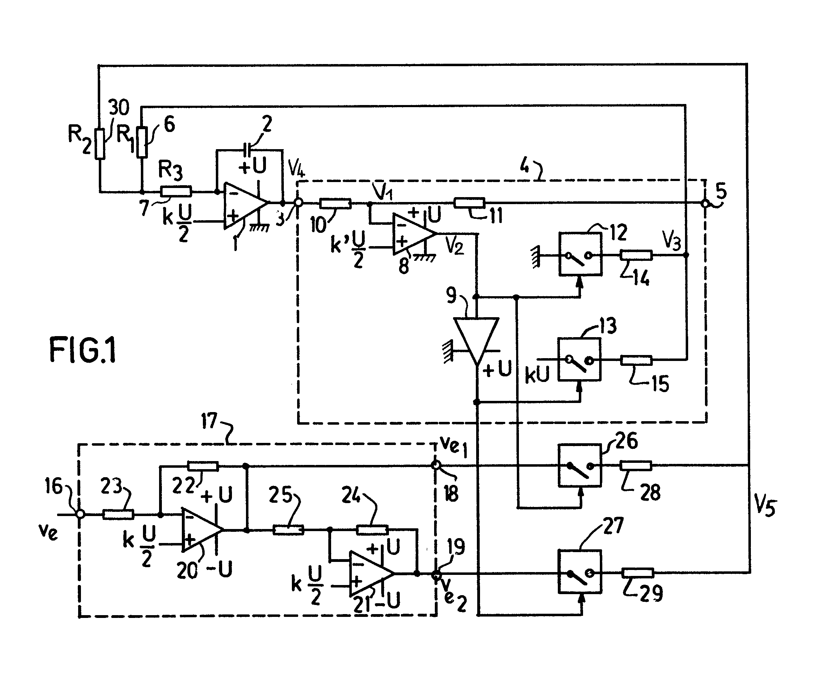

Le modulateur de l'invention représenté sur la figure 1 comporte un circuit intégrateur formé par un amplificateur opérationnel 1, par un condensateur 2 de capacité C connecté entre l'entrée inverseuse et la sortie de l'amplificateur 1 et enfin par un réseau de résistances branché à ladite entrée inverseuse et que l'on décrira par la suite. L'amplificateur opérationnel 1 est alimenté par une source de tension U et son entrée non inverseuse est portée au potentiel $K\frac{U}{2}$, étant un nombre inférieur à l'unité. La sortie de l'amplificateur opérationnel 1 est reliée à la borne d'entrée 3 d'une bascule à seuil avec hystérésis 4. La borne de sortie 5 de cette bascule est reliée à une borne d'une résistance 6 de valeur $R_1$ dont l'autre borne est connectée à l'entrée inverseuse de l'amplificateur 1 à travers une résistance 7 de valeur $R_3$. Une partie du circuit de ladite bascule à seuil est constituée par un amplificateur opérationnel 8 formant un comparateur suivi d'un inverseur 9, l'entrée inverseuse de l'amplificateur 8 étant reliée à la borne intermédiaire d'un pont de résistance 10, 11 connecté entre l'entrée 3 et la sortie 5 de la bascule à seuil et l'entrée non inverseuse de l'amplificateur 8 étant portée au potentiel $K'\frac{U}{2}$ avec $K < K'$ $< I$. L'amplificateur 8 et l'inverseur 9 sont également alimentés par la source de tension U.

Le dispositif décrit ci-dessus constitue un oscillateur du genre rencontré dans l'art antérieur et qui fournit une tension triangulaire à la sortie de l'amplificateur 1 lorsqu'une tension bivalente issue de la bascule à seuil 4 est appliquée à l'entrée du circuit intégrateur.

Dans le modulateur de la présente invention destiné à transmettre un signal de données analogique, ladite tension bivalente est formée à partir du potentiel O de la masse et du potentiel KU appliqués respectivement aux entrées des commutateurs analogiques 12 et 13 dont les sorties sont reliées à travers les résistances 14 et 15 à la borne de sortie 5 de la bascule à seuil. Les signaux d'entrée et de sortie de l'inverseur 9 servent respectivement à la commande des commutateurs 12 et 13. On obtient ainsi à ladite borne de sortie 5 une tension bivalente qui passe de la valeur O à la valeur kU quand la tension sur l'entrée inverseuse du comparateur 8 devient juste plus grande que le seuil de tension $k'\frac{U}{2}$ et qui passe de la valeur kU à la valeur O quand cette tension devient juste plus faible que le seuil de tension $k'\frac{U}{2}$. Ce fonctionnement de bascule à seuil se produit avec un certain hystérésis du fait que quand la tension de sortie de l'inverseur 9 passe de O à U, la tension sur l'entrée inverseuse du comparateur 8 remonte brusquement à une valeur plus grande que $k'\frac{U}{2}$ et quand la tension de sortie de l'inverseur 9 passe de U à O, cette tension tombe brusquement à une valeur plus faible que $k'\frac{U}{2}$.

Le signal de données analogique à transmettre $v_e$ est appliqué à la borne d'entrée 16 d'un circuit de transformation des données analogiques 17. Ce circuit qui fournit à une borne de sortie 18 une tension $v_{e1}$ et à une autre borne de sortie 19 une tension $v_{e2}$ est conçu pour que les tensions $v_{e1}$ et $v_{e2}$ soient variables linéairement en fonction de $v_e$ et symétriques par rapport au potentiel $k\frac{U}{2}$. Il est constitué par les amplificateurs opérationnels 20 et 21 alimentés entre les sources de tension $+U$ et $-U$ et ayant chacun son entrée non inverseuse portée au potentiel $k\frac{U}{2}$. L'entrée inverseuse de l'amplificateur 20 est reliée à sa sortie à travers une résistance 22 et à l'entrée 16 dudit circuit de transformation à travers une résistance 23. L'entrée inverseuse de l'amplificateur 21 est reliée à sa sortie à travers une résistance 24 et à la sortie de l'amplificateur 20 à travers une résistance 25 de même valeur que celle de la résistance 24. Les sorties des amplificateurs opérationnels 20 et 21 sont reliées respectivement aux sorties 18 et 19 du circuit 17 et aux entrées des commutateurs analogiques 26 et 27 dont les sorties sont reliées à travers les résistances 28 et 29 à une borne d'une résistance 30 de valeur $R_2$, l'autre borne de cette résistance étant commune avec celle de la résistance 6. Les résistances 6, 7 et 30 forment ledit réseau de résistances à l'entrée du circuit intégrateur. Les résistances 14, 15, 28 et 29 sont des résistances de protection contre la conduction simultanée des commutateurs analogiques. Les signaux d'entrée et de sortie de l'inverseur 9 servent respectivement à la commande des commutateurs 26 et 27. On obtient ainsi sur ladite borne de la résistance 30 une tension qui passe de la valeur $v_{e1}$ à la valeur $v_{e2}$ quand la tension sur l'entrée inverseuse du comparateur 8 devient juste plus grande que la tension du seuil $k'\frac{U}{2}$ et qui passe de la valeur $v_{e2}$ à la valeur $v_{e1}$ quand cette tension devient juste plus faible que la tension de seuil $k'\frac{U}{2}$.

Les circuits utilisés (amplificateurs opérationnels, commutateurs analogiques) fonctionnent sous une seule tension d'alimentation; la tension kU en sortie de la bascule à seuil, les tensions de référence $k\frac{U}{2}$ et $k'\frac{U}{2}$ appliquées aux entrées non inverseuses des amplificateurs opérationnels peuvent être obtenues par un pont diviseur de sorte que finalement le modulateur de l'invention ne nécessite qu'une seule source d'alimentation, ce qui, outre un avantage de simplicité contribue à la stabilité des fréquences vis-à-vis de la tension d'alimentation.

La fiabilité des circuits est accrue par leur mode de réalisation en circuits hybrides. Par ailleurs, l'art antérieur cité a mis en évidence la bonne stabilité des fréquences vis-à-vis des variations de température grâce notamment à la disposition de la résistance 7 entre l'entrée inverseuse de l'amplificateur opérationnel 1 et la borne commune aux résistances 6 et 30.

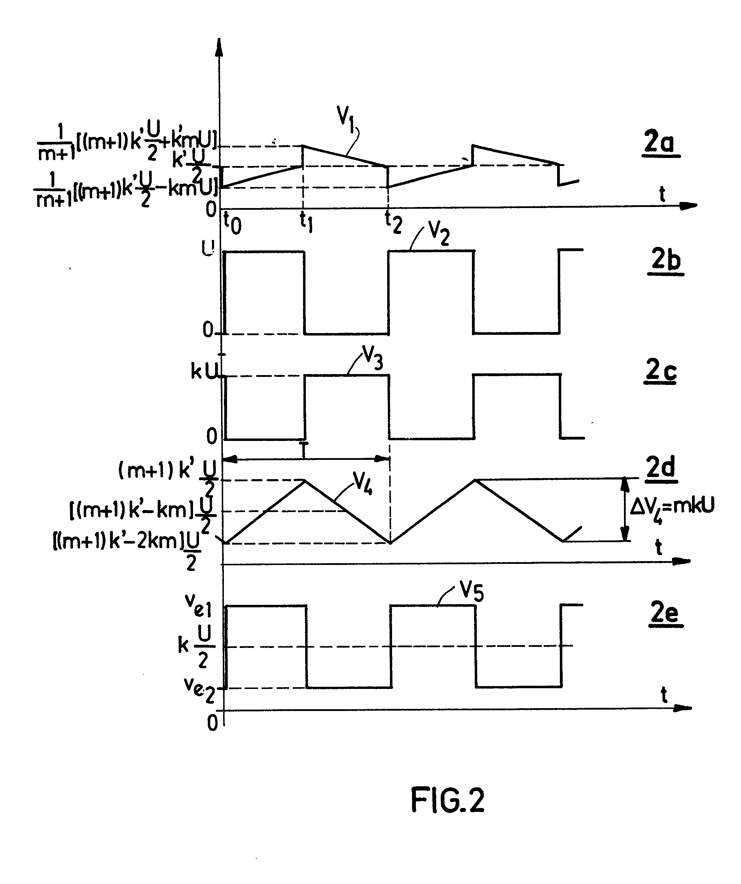

Le fonctionnement du modulateur de l'invention est illustré par les diagrammes de la figure 2. Le diagramme 2a représente la tension $V_1$ à l'entrée inverseuse du comparateur 8. Le diagramme 2b représente la tension $V_2$ à la sortie de ce comparateur. Le diagramme 2c représente la tension bivalente $V_3$ à la sortie de la bascule à seuil 4. Le diagramme 2d représente la tension de sortie $V_4$ de l'oscillateur prise à la sortie de l'amplificateur opérationnel 1. Le diagramme 2e représente la tension $V_5$ formée à la sortie des commutateurs 26 et 27 et dont l'amplitude est une fonction du signal de données analogiques $v_e$ (il faut remarquer que la fréquence de l'oscillateur étant élevée devant les fréquences de la bande de base du signal de données, les variations de ce dernier n'ont qu'une faible influence sur l'amplitude de la tension $V_5$ pendant quelques périodes de cette tension).

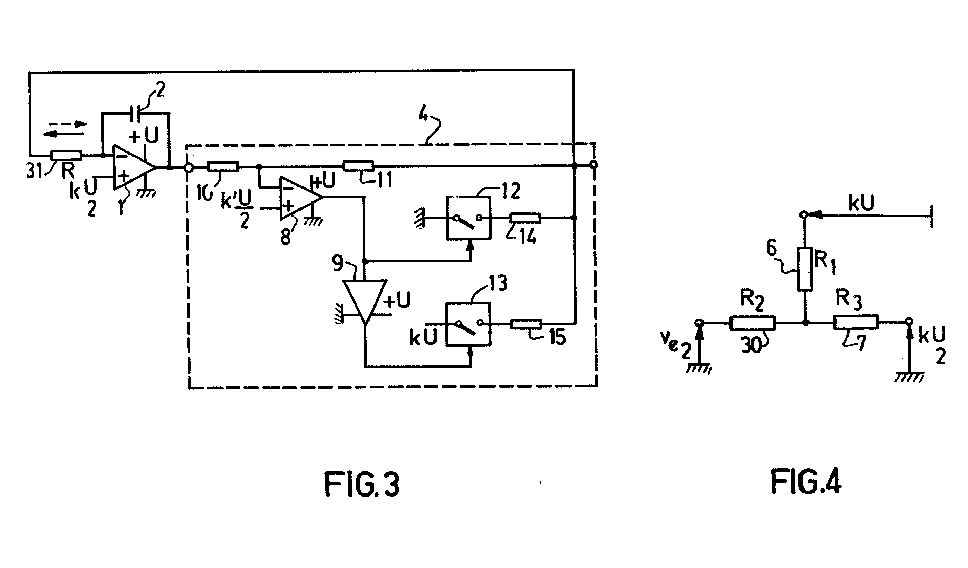

En vue de décrire le fonctionnement du modulateur de l'invention, on va d'abord expliquer le fonctionnement de l'oscillateur de base utilisé dans ce modulateur. Cet oscillateur de base représenté sur la figure 3 comporte certains éléments de la figure 1 munis des mêmes références, c'est-à-dire l'amplificateur opérationnel 1, le condensateur 2 et la bascule à seuil 4, celle-ci comportant le comparateur 8, l'inverseur 9, le pont de résistances 10, 11 et les commutateurs 12 et 13. Dans cet oscillateur de base, la tension bivalente $V_3$ à la sortie de la bascule à seuil est appliquée à une borne d'une seule résistance 31 de valeur R dont l'autre borne est reliée à l'entrée inverseuse de l'amplificateur opérationnel 1.

L'examen des diagrammes de la figure 2 montre que si l'on se place d'abord juste avant l'instant $t_0$ où la tension $V_1$ décroissante atteint la valeur $k' \dfrac{U}{2}$ appliquée à l'entrée inverseuse du comparateur 8, la tension $V_3$ vaut alors kU. Le même courant circulant dans les résistances 10 et 11 dont le rapport des valeurs est m, on en déduit aisément que la tension $V_4$ à la sortie de l'amplificateur 1 a la valeur minimale $V_{4m}$ telle que:

$$V_{4m} = \left[ (m+1)k' - 2\,km\,\frac{U}{2} \right]$$

A l'instant $t_0$, le comparateur 8 bascule, la tension $V_3$ à la sortie de la bascule à seuil prend une valeur nulle et la tension $V_1$ descend brusquement à une valeur inférieure à $k' \dfrac{U}{2}$. Comme la tension sur l'entrée non inverseuse de l'amplificateur opérationnel 1 dont on suppose le gain infini est égale à $k \dfrac{U}{2}$, le courant dans la résistance 31 vaut $\dfrac{kU}{2R}$ et circule dans le sens indiqué par la flèche en trait plein. La tension de sortie $V_4$ croît alors linéairement avec la pente $\dfrac{kU}{2RC}$.

La tension $V_1$ croît également linéairement et on peut montrer aisément que juste avant l'instant $t_1$ où elle atteint la valeur de la référence $k' \dfrac{U}{2}$ appliquée à l'entrée non inverseuse du comparateur 8, la tension de sortie $V_4$ atteint la valeur maximale $V_{4M}$ telle que:

$$V_{4M} = (m+1)k' \frac{U}{2}.$$

A l'instant $t_1$, le comparateur 8 bascule, la sortie de la bascule à seuil 4 fournit la tension $V_3 = kU$ et la tension $V_1$ monte brusquement à une valeur supérieure à $k' \dfrac{U}{2}$. Le courant dans la résistance 31 s'inverse alors et circule dans le sens de la flèche en trait pointillé tout en gardant l'amplitude $\dfrac{kU}{2R}$. La tension de sortie $V_4$ décroît linéairement avec la pente $- \dfrac{kU}{2RC}$.

A l'instant $t_2$, le fonctionnement est identique à celui que l'on a expliqué pour l'instant $t_0$.

A partir des résultats ci-dessus, on peut calculer la fréquence F de la tension de sortie triangulaire $V_4$ de l'oscillateur. Pour une variation $\Delta V_4$ de cette tension pendant l'intervalle de temps $\Delta t$, l'expression générale du courant de charge ou de décharge du condensateur 2 est $I = \dfrac{\Delta V_4}{\Delta t}$. Ce courant circulant dans la résistance 31 a pour valeur $I = \dfrac{kU}{2R}$ comme on l'a montré ci-dessus. Si l'on prend comme variation $\Delta V_4$ la différence des valeurs maximale et minimale de la tension $V_4$, $\Delta V_4 = kmU$. On voit sur le diagramme 2d que l'intervalle de temps $\Delta t$ correspondant est égal à la demi-période $\dfrac{T}{2}$ de l'oscillateur. On en déduit donc la valeur de la fréquence:

$$F = \frac{1}{T} = \frac{1}{4mRC}$$

Cette valeur F est indépendante de la tension d'alimentation U.

La valeur moyenne de la tension $V_4$ a pour expression:

$$V_{4moy} = \frac{1}{2}(V_{4m} + V_{4M}) = \left[ (m+1)k' - km \right] \frac{U}{2}$$

Pour que cette valeur moyenne soit égale à $\dfrac{U}{2}$, on doit avoir la relation suivante entre les coefficients k et k':

$$\frac{km+1}{m+1} = k'$$

Cette relation peut être utilisée pour centrer sur $\frac{U}{2}$ le signal d'entrée d'un filtre connecté à la sortie de l'amplificateur 1. Si l'on a par exemple $m = \frac{1}{2}$, $k = \frac{3}{4}$ (U = 12V et kU = 9V), la valeur de k' est de $\frac{11}{12}$.

Dans le cas du modulateur de l'invention de la figure 1, le courant de charge ou de décharge du condensateur 2 est égal au courant traversant la résistance commune 7 du réseau des résistances connecté à l'entrée inverseuse de l'amplificateur 1. La valeur de ce courant est à déterminer selon la position des commutateurs 26 et 27 établissant la variation de la tension $V_5$ entre les valeurs $v_{e1}$ et $v_{e2}$ proportionnelles au signal de données.

On suppose par exemple que le commutateur 26 est commandé sur sa position ouverte. Le commutateur 27 est alors commandé sur sa position fermée de sorte que la tension $V_5$ a pour valeur $v_{e2}$. Le courant I s'obtient aisément en examinant le schéma de la figure 4 qui montre le réseau des résistances 6, 7 et 30 branchées entre elles comme sur la figure 1. Une extrémité de la résistance 7 qui est parcourue par le courant I est toujours à une tension pratiquement égale à $k\frac{U}{2}$, si l'on suppose que le gain de l'amplificateur opérationnel 1 est infini. Lorsque la tension $V_5$ a pour valeur $v_{e2}$, les extrémités des résistances 6 et 30 non reliées à la résistance 7 sont portées respectivement aux valeurs de tension kU et $v_{e2}$ indiquées sur la figure 4. Un calcul usuel montre que le courant I traversant la résistance 7 a pour valeur en posant $\frac{1}{R_1} = Y_1$ et $\frac{1}{R_2} = Y_2$:

$$I = \frac{-Y_2(k\frac{U}{2} - v_{e2}) + Y_1 k\frac{U}{2}}{1 + R_3(Y_1 + Y_2)}$$

En reportant cette valeur dans la relation $I = C\frac{\Delta V_4}{\Delta t}$, on obtient avec les valeurs de $\Delta V_4$ et de $\Delta t$ définies ci-dessus la fréquence fournie par le modulateur de l'invention en fonction de la tension $v_{e2}$.

$$F = \frac{-Y_2(k\frac{U}{2} - v_{e2}) + Y_1 k\frac{U}{2}}{1 + R_3(Y_1 + Y_2)} \cdot \frac{1}{2\,C\,km\,U}$$

Les tensions $v_{e1}$ et $v_{e2}$ sont fournies par le circuit de transformation des données analogiques 17.

Pour établir la loi de variation des tensions $v_{e1}$ et $v_{e2}$ en fonction de $v_e$, on écrit la loi de Kirchoff aux points communs des résistances 22 et 23 d'une part, 24 et 25 d'autre part. Il en résulte les relations:

$$v_{e1} = k\frac{U}{2} - A(v_e - k\frac{U}{2})$$

$$v_{e2} = k\frac{U}{2} + A(v_e - k\frac{U}{2})$$

dans lesquelles A est le rapport des valeurs des résistances 22 et 23.

Ainsi les tensions $v_{e1}$ et $v_{e2}$ fournies par le circuit 17 présentent une variation linéaire en fonction du signal de données $v_e$ tout en restant symétriques par rapport à la tension $k\frac{U}{2}$, valeur moyenne des potentiels appliqués aux entrées des commutateurs 12 et 13.

En reportant l'expression ci-dessus de $v_{e2}$ dans la formule donnant la fréquence fournie par le modulateur en fonction de $v_{e2}$, on obtient l'expression générale suivante de cette fréquence en fonction du signal de données analogiques $v_e$:

$$F = \frac{Y_1 - AY_2}{1 + R_3(Y_1 + Y_2)} \cdot \frac{1}{4Cm} + \frac{AY_2}{1 + R_3(Y_1 + Y_2)} \cdot \frac{1}{2C\,km\,U} v_e$$

Cette expression se décompose en deux parties: une partie fixe $F_0$ indépendante de la tension d'alimentation U et une partie variable $\Delta F$ en fonction du signal de données:

$$\left.\begin{array}{l} F_0 = \dfrac{Y_1 - AY_2}{1 + R_3(Y_1 + Y_2)} \cdot \dfrac{1}{4Cm} \\[2em] \Delta F = \dfrac{AY_2}{1 + R_3(Y_1 + Y_2)} \cdot \dfrac{1}{2C\,km\,U} v_e \end{array}\right\} \quad (1)$$

On voit ainsi que $F < F_0$ si $v_e < 0$
$F > F_0$ si $v_e > 0$

On va maintenant établir les formules permettant de déterminer les valeurs de résistances $R_1$ et $R_2$ pour une fréquence centrale $F_0$ et une excursion de fréquence $\Delta F$ résultant d'un signal de données $v_e$.

On tire de (1):

$$\frac{\Delta F}{F_0} = \frac{2A\,Y_2\,v_e}{kU(Y_1 - Y_2)}$$

La transformation de cette expression donne une première relation entre $Y_1$ et $Y_2$:

$$Y_1 = Y_2 \left(A + \frac{2A\,F_o}{\Delta F} \cdot \frac{v_e}{kU}\right) \qquad (2)$$

En introduisant par ailleurs le rapport $\frac{\Delta F}{F_o}$ dans l'expression de $F_o$, celle-ci s'écrit:

$$F_o = \frac{2A\,v_e\,Y_2\,F_o}{\Delta F\,kU[1+R_3(Y_1+Y_2)]} \cdot \frac{1}{4Cm}$$

La transformation de cette expression fait apparaître une seconde relation entre $Y_1$ et $Y_2$:

$$Y_1 = Y_2\left(\frac{1}{R_3}\frac{2A\,v_e}{\Delta F\,kU} \cdot \frac{1}{4Cm} - 1\right) - \frac{1}{R_3} \qquad (3)$$

L'élimination de $Y_1$ entre les relations (2) et (3) donne:

$$R_2 = R_3\left[\frac{2A\,v_e}{\Delta F\,kU}\left(\frac{1}{4R_3Cm} - F_o\right) - 1 - A\right] \qquad (4)$$

Cette dernière relation (4) permet de déterminer $R_2$ si l'on s'est fixé $R_3$. La valeur $R_1$ est ensuite calculée au moyen de l'une quelconque des relations (2) ou (3).

Il est possible de modifier la fréquence centrale $F_o$ par modification des valeurs de résistances $R_1$ et $R_2$.

Pour réaliser un modulateur, on peut par exemple se fixer les valeurs de tension kU, de capacité C, de résistance $R_3$ ainsi que les rapports de résistances m et A.

Par exemple, dans le cas d'un modulateur assurant une transmission conforme à l'avis V 16 du CCITT «Modem pour transmission de données analogiques médicales», trois sous-porteuses $F_o$ peuvent être utilisées (905 Hz, 1400 Hz et 2100 Hz) avec une excursion maximale $\Delta F_{max}$ de 100 Hz et une pente de la caractéristique de 40 Hz/V.

Si l'on s'est fixé:
kU=9V, C=2,7nF, $R_3$=83 kΩ, m=0,5, A=0,37
on calcule pour la voie analogique centrale ($F_o$ = 1400 Hz):

$$R_2=28\,k\Omega,\ R_1=8,6\,k\Omega.$$

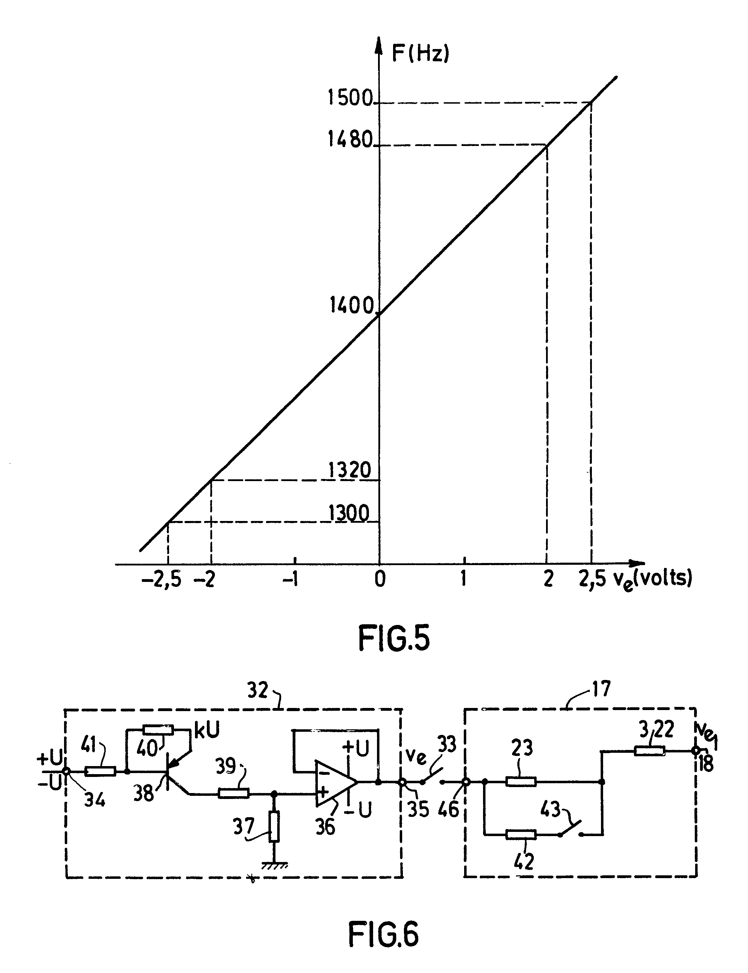

La figure 5 donne la caractéristique $F(v_e)$ de ce modulateur.

On voit sur cette caractéristique qu'une excursion de fréquence de 100 Hz correspond à une variation du signal de données comprise entre −2,5 V et +2,5 V.

Les expressions de $v_{e1}$ et $v_{e2}$ établies ci-dessus donnent:
− lorsque $v_e$ = +2,5 V: $v_{e1}$=5,24 V et $v_{e2}$=3,76 V
− lorsque $v_e$=−2,5 V: $v_{e1}$=7,08 V et $v_{e2}$=1,92 V

L'avis V 16 du CCITT prévoit la possibilité d'utilisation de la voie analogique centrale pour transmettre des données numériques à la vitesse maximale de 100 Bauds dans les conditions suivantes:
symbole 1 (repos) pour $F_1$ = 1400 Hz − 80 Hz
symbole 0 (travail) pour $F_2$ = 1400 Hz + 80 Hz.

Le déplacement de fréquence de ±80 Hz correspond sur la caractéristique à $v_2 = \pm 2$ V.

Les valeurs de $v_{e1}$ et $v_{e2}$ étant calculées avec les valeurs de paramètres indiquées ci-dessus (kU=9V, A=0,37), on obtient:
− lorsque $v_e$ = +2 V: $v_{e1}$=5,42 V et $v_{e2}$=3,57 V
− lorsque $v_e$=−2 V: $v_{e1}$=6,90 V et $v_{e2}$=2,10 V

Si l'on fournit à l'entrée du circuit 17 une valeur $v_e$ = 0 V au lieu de $v_e$ = 2 V par exemple, il faut pour maintenir la valeur $v_{e1}$ obtenue avec $v_e$ = 2 V, recalculer A au moyen de l'expression de $v_{e1}$, les autres paramètres étant inchangés.
− Avec $v_{e1}$=6,9 V, kU=9 V et $v_e$=0, on obtient A=0,53
(on aurait obtenu le même résultat à partir de $v_{e2}$=2,10 V).

Avec cette nouvelle valeur du paramètre A, il faut appliquer une autre valeur $v_e$ qui maintient la valeur $v_{e1}$ = 5,42 V calculée avec $v_e$=+2 V. Le calcul donne: $v_e$ = 2,76 V
(on aurait obtenu le même résultat à partir de $v_{e2}$=3,57 V).

Pour fixer cette nouvelle valeur du paramètre A, il suffit de modifier le rapport des valeurs des résistances 22 et 23 du circuit 7. Les valeurs de tension à appliquer à l'entrée 16 de ce circuit sont alors:
− $v_e$ = 0 V pour obtenir $F_1$ = 1400 Hz − 80 Hz
− $v_e$ = 2,76 V pour obtenir $F_2$ = 1400 Hz + 80 Hz.

Ces valeurs $v_e$ sont fournies en sortie d'un circuit de transformation des données numériques 32 dont le schéma est représenté sur la figure 6 et transmises à travers un interrupteur 33 à la borne d'entrée 16 du circuit de transformation des données analogiques. Ce circuit 32 est conçu de façon qu'à partir d'un signal de commande des données numériques appliqué à sa borne d'entrée 34 et dont les valeurs de potentiel sont +U et −U, on obtient à sa borne de sortie 35 un autre signal de commande qui est appliqué à la borne d'entrée 16 du circuit 17 pour produire ledit déplacement de fréquence. A cet effet, il comporte un amplificateur opérationnel 36 alimenté entre les sources de tension +U et −U, dont la sortie reliée à ladite borne de sortie 35 est rétrocouplée sur son entrée inverseuse et dont l'entrée non inverseuse est reliée d'une part à la masse à travers une résistance 37 de valeur $r_1$ et d'autre part au collecteur d'un transistor 38 de type PNP à travers une résistance 38 de valeur $r_2$. La base de ce transistor est reliée à son émetteur porté au potentiel kU à travers une résistance 40 et à la borne d'entrée 34 du circuit à travers une résistance 41. Cette borne 34 reçoit le signal de commande des données numériques dont les valeurs de potentiel sont +U et −U.

On a représenté également sur la figure 6 la modification qui doit être apportée dans le circuit 17 pour obtenir la nouvelle valeur A = 0,53. Cette modification consiste à disposer en parallèle aux bornes de la résistance 23 une résistance 42 en série avec un interrupteur 43. La valeur de la résistance 42 est de 23,1 kΩ pour des valeurs des résistances 22 et 23 égales respectivement à 3,7 kΩ et 10 kΩ.

Dans le fonctionnement en transmission de données numériques, les interrupteurs 33 et 43 sont fermés. La sortie du circuit 32 fournit alors la tension $v_e$ et le rapport A passe de 0,37 à 0,53.

Pour déterminer les éléments du circuit 25 de manière à obtenir les valeurs $v_e$ (2,76 V ou 0 V) évaluées ci-dessus, on calcule les différences de potentiel aux bornes des résistances 37 et 39.

Lorsque le potentiel − U est appliqué à l'entrée 34 du circuit, le transistor 38 est à l'état conducteur et un courant i circule dans les résistances 37 et 39. Le gain de l'amplificateur opérationnel 36 étant supposé infini, sa tension de sortie $v_e$ ramenée à son entrée inverseuse se retrouve à son entrée non inverseuse. On a donc pour la différence de potentiel aux bornes de la résistance 37 : $r_1 i = v_e$. Par ailleurs si le transistor 38 est saturé, la différence de potentiel entre collecteur et émetteur peut être considérée comme négligeable de sorte que le potentiel kU se retrouve sur le collecteur. La différence de potentiel aux bornes de la résistance 39 s'écrit alors : $r_2 i = kU − v_e$. Le rapport de ces deux différences de potentiel est égal au rapport des résistances 39 et 37 qui a pour expression :

$$\frac{r_2}{r_1} = \frac{kU}{v_e} - 1$$

Pour obtenir la valeur $v_e$ = 2,76 V avec kU = 9 V, on doit avoir $\frac{r_2}{r_1}$ = 2,26.

Si l'on se fixe $r_1$ = 10 kΩ, alors $r_2$ = 22,6 kΩ.

Lorsque le potentiel + U est appliqué sur la borne d'entrée 26, le transistor 38 est à l'état bloqué. Aucun courant ne circule dans les résistances 37 et 39. On a donc : $r_1 i = v_e$ = 0 V.

**Revendications**

1. Modulateur destiné à transmettre un signal de données analogiques par la variation de la fréquence d'un oscillateur comportant un premier amplificateur opérationnel (1) monté avec un condensateur (2) pour former un intégrateur dont la sortie est reliée à l'entrée (3) d'une bascule à seuil (4) avec hystérésis, la sortie (5) de la bascule à seuil fournissant une tension bivalente étant connectée à une borne d'une première résistance (6) dont l'autre borne est à relier à l'entrée dudit intégrateur de façon à former à la sortie de ce dernier une tension triangulaire dont la fréquence dépend du courant qui la traverse, ladite bascule à seuil (4) étant constituée par un deuxième amplificateur opérationnel (8) suivi d'un inverseur (9), une entrée dudit deuxième amplificateur opérationnel étant reliée à la borne intermédiaire d'un pont de résistances (10, 11) connecté entre lesdites sorties de l'intégrateur et de la bascule à seuil, caractérisé en ce que ladite tension bivalente est formée à partir du potentiel zéro de la masse et d'un potentiel positif fixe (kU) inférieur à la tension d'alimentation U appliqués respectivement aux entrées d'un premier et d'un deuxième commutateur analogique (12, 13) dont les sorties communes sont reliées à ladite sortie (5) de la bascule à seuil, les signaux d'entrée et de sortie dudit inverseur servant à commander respectivement lesdits premier et deuxième commutateurs (12, 13), ledit signal de données étant appliqué à l'entrée d'un circuit de transformation des données analogiques (17) agencé pour fournir à ses sorties (18, 19) une première et une seconde tension variables en fonction du signal de données, de façon symétrique par rapport à la moyenne des potentiels fixes à l'entrée desdits premier et deuxième commutateurs, lesdites première et seconde tensions variables étant appliquées respectivement aux entrées d'un troisième et d'un quatrième commutateur analogiques (26, 27) ayant leurs sorties communes reliées à une borne d'une deuxième résistance (30) dont l'autre borne est commune avec celle de ladite première résistance, lesdits signaux d'entrée et de sortie de l'inverseur servant à commander respectivement lesdits troisième et quatrième commutateurs (26, 27).

2. Modulateur selon la revendication 1, caractérisé en ce que ledit circuit de transformation des données analogiques (17) est constitué par un troisième amplificateur opérationnel (20) et un quatrième amplificateur opérationnel (21) ayant chacun une entrée portée à ladite moyenne des tensions fixes appliquées aux entrées des premier et deuxième commutateurs, l'autre entrée du troisième amplificateur opérationnel étant reliée à sa sortie à travers une troisième résistance et à ladite entrée dudit circuit de transformation à travers une quatrième résistance, l'autre entrée du quatrième amplificateur opérationnel étant reliée à sa sortie à travers une cinquième résistance et à la sortie dudit troisième amplificateur opérationnel à travers une sixième résistance de même valeur que celle de la cinquième résistance, les sorties desdits troisième et quatrième amplificateurs opérationnels étant lesdites sorties du circuit de transformation des données analogiques.

3. Modulateur selon l'une des revendications 1 à 2, caractérisé en ce qu'il peut transmettre également un signal de données numérique par un déplacement de fréquence donné en connectant à l'entrée dudit circuit de transformation des données analogiques la sortie d'un circuit de transformation des données numériques transformant un signal de commande appliqué à son entrée et dont les valeurs de potentiel sont + U et − U en un autre signal de commande dont les valeurs de potentiel sont déterminées pour produire ledit déplacement de fréquences.

4. Modulateur selon l'une quelconque des revendications 1, 2 ou 3, caractérisé en ce que tous les circuits utilisés fonctionnent sous une alimentation unique, symétrique par rapport à la masse (+ U, − U).

## Claims

1. A modulator for transmitting an analog data signal by variation of the frequency of an oscillator comprising a first operational amplifier (1) combined with a capacitor (2) to form an integrator whose output is connected to the input (3) of a bistable circuit (4) with trigger hysteresis, the output (5) of the bistable circuit supplying a two-level voltage which is applied to one terminal of a first resistor (6) whose other terminal is connected to the input of said integrator so as to produce at its output a triangular wave voltage whose frequency depends on the current flowing through said first resistor, said bistable circuit (4) being formed by a second operational amplifier (8) followed by an inverter (9), one input of this second operational amplifier being connected to the intermediate terminal of a resistor bridge (10, 11) connected between the outputs of said integrator and said bistable circuit, characterized in that said two-level voltage is formed from zero ground potential and a fixed positive potential (kU) lower than the supply voltage U, applied respectively to the inputs of a first and second analog switch whose common outputs are connected to said output (5) of the bistable circuit, the input and output signals of said inverter being used to control said first and second switches (12, 13), respectively said data signal being applied to the input of an analog data conversion circuit (17) arranged so as to supply at its outputs (18, 19) a first and a second voltage which are variable as a function of the data signal and symmetrical with respect to the mean value of the fixed potentials at the inputs of said first and second switches, said first and second variable voltages being respectively applied to the inputs of a third and a fourth analog switch (26, 27) having their common outputs connected to one terminal of a second resistor (30) whose other terminal is common with that of said of first resistor, the input and output signals of said inverter being used to control said third and fourth switches (26, 27) respectively.

2. A modulator as claimed in Claim 1, characterized in that said analog data conversion circuit (17) is constituted by a third operational amplifier (20) and a fourth operational amplifier (21) each having an input receiving said mean value of the fixed voltages applied to the inputs of said first and second switches, the other input of the third operational amplifier being connected to its output through a third resistor and to the input of the said conversion circuit through a fourth resistor, the other input of the fourth operational amplifier being connected to its input through a fifth resistor and to the output of said third operational amplifier through a sixth resistor of the same value as the fifth resistor, the outputs of said third and fourth operational amplifiers being said outputs of the analog data conversion circuit.

3. A modulator as claimed in one of the Claims 1 and 2, characterized in that the modulator is also capable of transmitting a digital data signal with the aid of given frequency shift by connecting to the input of said analog data conversion circuit the output of a digital data conversion circuit converting a control signal applied to its unit and whose potential values are +U and −U into another control signal whose potential values are chosen such as to produce said frequency shift.

4. A modulator as claimed in any one of the Claims 1, 2 and 3, characterized in that all the circuits used are fed with a single supply voltage, symmetrical with respect to ground (+U, −U).

## Patentansprüche

1. Modulator zum Übertragen eines analogen Datensignals durch Änderung der Frequenz eines Oszillators mit einem ersten Operationsverstärker (1), der mit einem Kondensator (2) zum Bilden eines Integrators kombiniert ist, dessen Ausgang an den Eingang (3) einer Flip-Flop-Schaltung (4) mit Schwellen-Hysterese angeschlossen ist, wobei der Ausgang (5) der eine zweiwertige Spannung liefernden Flip-Flop-Schaltung an eine Klemme eines ersten Widerstandes (6) angeschlossen ist, dessen andere Klemme derart an den Eingang des genannten Integrators angeschlossen ist, dass am Ausgang des letzteren eine Dreieckspannung gebildet wird, deren Frequenz von dem durch die Flip-Flop-Schaltung fliessenden Strom abhängig ist, wobei die genannte Flip-Flop-Schaltung (4) aus einem zweiten Operationsverstärker (8) und einem darauffolgenden Inverter (9) besteht, wobei ein Eingang des genannten zweiten Operationsverstärkers mit dem Mittenabgriff einer Widerstandsbrücke (10, 11) angeschlossen ist, die zwischen den genannten Ausgängen des Integrators und der Flip-Flop-Schaltung liegt, dadurch gekennzeichnet, dass die genannte zweiwertige Spannung aus dem Nullpotential der Masse und einem festen Potential (kU), das niedriger ist als die Speisespannung U, gebildet wird und diese Potentiale den Eingängen eines ersten bzw. zweiten analogen Schalters (12, 13) zugeführt werden, deren gemeinsame Ausgänge an den genannten Ausgang (5) der Flip-Flop-Schaltung angeschlossen sind, wobei die Ein- und Ausgangssignale des genannten Inverters zum Steuern des genannten ersten bzw. zweiten Schalters (12, 13) dienen und wobei das genannte Datensignal dem Eingang einer Schaltungsanordnung zur Umwandlung analoger Daten (17) zugeführt wird, welche Schaltungsanordnung an ihren Ausgängen (18, 19) eine erste und eine zweite Spannung liefert, die abhängig von dem Datensignal veränderlich sind und zwar symmetrisch gegenüber dem Mittelwert der festen Potentiale an dem Eingang des genannten ersten und zweiten Schalters, wobei die genannte erste und zweite veränderliche Spannung dem Eingang eines dritten bzw. vierten analogen Schalters (26, 27) zugeführt werden, deren gemeinsame Ausgänge an eine Klemme eines zweiten Widerstandes (30) angeschlossen sind, dessen andere Klemme mit der des genannten ersten Widerstandes gemeinsam ist, wobei die genannten Ein- und Ausgangssignale des Inverters den dritten bzw. vierten Schalter (26, 27) steuern.

2. Modulator nach Anspruch 1, dadurch gekennzeichnet, dass die genannte Schaltungsanordnung zur Umwandlung analoger Daten (17) aus einem dritten Operationsverstärker (20) und einem vierten Operationsverstärker (21) besteht, welche Operationsverstärker je einen Eingang auf dem Mittelwert der festen Spannungen aufweisen, die den Eingängen des ersten und zweiten Schalters zugeführt werden, wobei der andere Eingang des dritten Operationsverstärkers über einen dritten Widerstand an seinen Ausgang und über einen vierten Widerstand an dem genannten Eingang der genannten Umwandleranordnung angeschlossen ist, wobei der andere Eingang des vierten Operationsverstärkers über einen fünften Widerstand an seinen Ausgang angeschlossen ist und über einen sechsten Widerstand mit demselben Wert wie der des fünften Widerstandes an dem Ausgang des genannten dritten Operationsverstärkers angeschlossen ist, wobei die Ausgänge des genannten dritten und vierten Operationsverstärkers die genannten Ausgänge der Schaltungsanordnung zur Umwandlung analoger Daten sind.

3. Modulator nach einem der Ansprüche 1 und 2, dadurch gekennzeichnet, dass er ebenfalls ein digitales Datensignal durch eine gegebene Frequenzumtastung übertragen kann und zwar dadurch, dass der Eingang der genannten Schaltungsanordnung zur Umwandlung analoger Daten mit dem Ausgang einer Schaltungsanordnung zur Umwandlung digitaler Daten verbunden wird, wobei diese letzte Schaltungsanordnung ein ihrem Eingang zugeführtes Steuersignal, dessen Potentialwerte $+U$ und $-U$ sind, in ein anderes Steuersignal umwandelt, dessen Potentialwerte zum Durchführen der genannten Frequenzumtastung bestimmt sind.

4. Modulator nach einem der Ansprüche 1, 2 oder 3, dadurch gekennzeichnet, dass alle verwendeten Schaltungsanordnungen mit einer einzigen, gegenüber Masse symmetrischen Speisung ($+U$, $-U$) arbeiten.

FIG.1

**FIG.2**

FIG.4

FIG.3

**FIG.5**

**FIG.6**